# EUROPÄISCHE PATENTSCHRIFT

(11) **EP 0 907 966 B1**
(45) Veröffentlichungstag und Bekanntmachung des Hinweises auf die Patenterteilung: **06.02.2002**
(21) Anmeldenummer: 97929127.5
(22) Anmeldetag: 19.06.1997
(51) Int. Cl.: H01L 23/495

(54) **INTEGRIERTE HALBLEITERSCHALTUNG**
INTEGRATED SEMICONDUCTOR CIRCUIT
CIRCUIT INTEGRE A SEMI-CONDUCTEUR

(30) Priorität: 28.06.1996 DE 19626087
(43) Veröffentlichungstag der Anmeldung: 14.04.1999
(73) Patentinhaber: Infineon Technologies AG, 81669 München (DE)
(72) Erfinder: POHL, Jens, D-93170 Bernhardswald (DE); GOLZ, Bruno, D-82287 Jesenwang (DE); WIDNER, Harald, D-93326 Abensberg (DE)
(74) Vertreter: Zedlitz, Peter, Dipl.-Inf.
(86) Internationale Anmeldenummer: DE9701273
(87) Internationale Veröffentlichungsnummer: WO9800867

(56) Entgegenhaltungen:
- PATENT ABSTRACTS OF JAPAN vol. 014, no. 046 (M-0926), 26.Januar 1990 & JP 01 275196 A (MATSUSHITA ELECTRIC IND CO LTD), 2.November 1989,
- PATENT ABSTRACTS OF JAPAN vol. 009, no. 133 (P-362), 8.Juni 1985 & JP 60 015786 A (DAINIPPON INSATSU KK), 26.Januar 1985,
- PATENT ABSTRACTS OF JAPAN vol. 018, no. 643 (E-1640), 7.Dezember 1994 & JP 06 252333 A (HITACHI CONSTR MACH CO LTD), 9.September 1994,
- PATENT ABSTRACTS OF JAPAN vol. 016, no. 462 (E-1269), 25.September 1992 & JP 04 162640 A (HITACHI LTD), 8.Juni 1992,
- PATENT ABSTRACTS OF JAPAN vol. 013, no. 295 (E-783), 7.Juli 1989 & JP 01 074748 A (NEC CORP), 20.März 1989,
- PATENT ABSTRACTS OF JAPAN vol. 016, no. 014 (E-1154), 14.Januar 1992 & JP 03 235360 A (NEC CORP), 21.Oktober 1991,

## Beschreibung

Die vorliegende Erfindung bezieht sich auf eine integrierte Halbleiterschaltung, insbesondere einen Halbleiterspeicher, mit einem Halbleiterchip, einem den Halbleiterchip aufnehmenden Gehäuse und einem Leiterrahmen zur Verbindung zwischen Kontaktflächen des Halbleiterchips und äußeren Anschlüssen der integrierten Halbleiterschaltung, wobei mit den Kontaktflächen verbundene erste Bereiche des Leiterrahmens und mit den äußeren Anschlüssen verbundene zweite Bereiche des Leiterrahmens im wesentlichen in einer gleichen Ebene gelegen sind.

Für Halbleiterspeicher, beispielsweise 16-Megabit-Halbleiterspeicher können sogenannte TSOP-Gehäuse (TSOP = Thin small outline package) mit einer Gehäusedicke von etwa 1 mm oder auch sogenannte SOJ-Gehäuse (SOJ = Small Outline J-Bend) mit einer Gehäusedicke von etwa 2,5 mm verwendet werden. Werden diese Gehäuse in der LOC-Technik (LOC = Lead-On-Chip) aufgebaut, so sind Gehäuseanschlüsse nicht punktsymmetrisch bzw. zentrisch am Gehäuse angebracht. Gleiches gilt auch für die Führung der Leiter des Leiterrahmens, die jeweilige Kontaktflächen bzw. -flecken des Halbleiterchips mit den Gehäuseanschlüssen verbinden. Die Kontaktflächen dienen dabei zur mechanischen Befestigung des Halbleiterchips am Leiterrahmen, während die elektrische Verbindung über beispielsweise Golddrähte zu Bondpads erfolgt.

Ist nun der Halbleiterchip sehr viel kleiner als das Gehäuse, was dann der Fall sein kann, wenn ein bereits vorhandenes Gehäuse für einen erheblich kleineren Halbleiterchip eingesetzt werden soll, so liegen relativ große Bereiche im Gehäuse vor, in denen kein Halbleiterchip vorhanden ist.

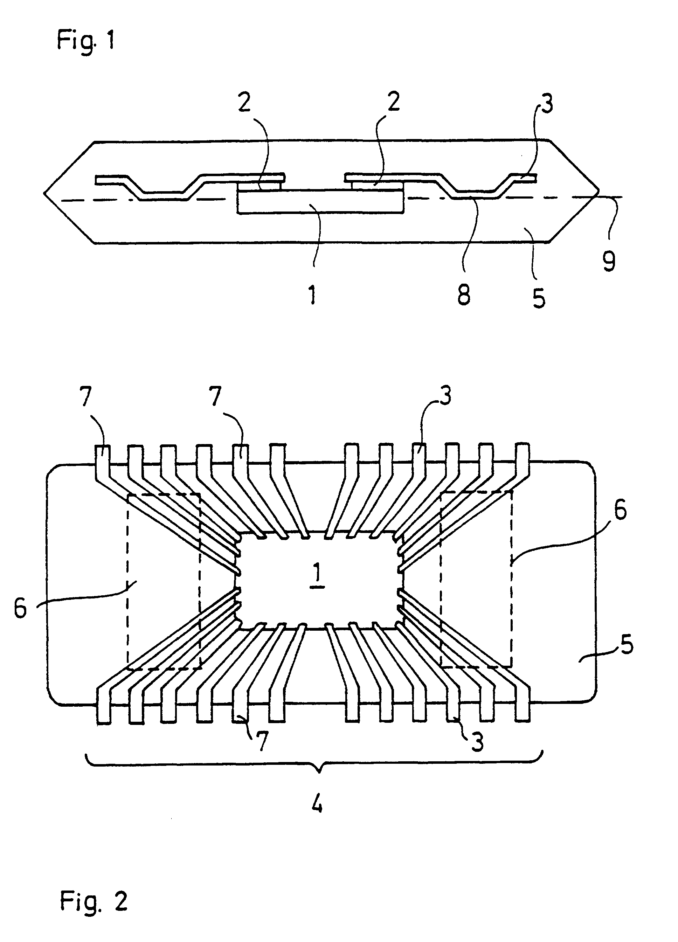

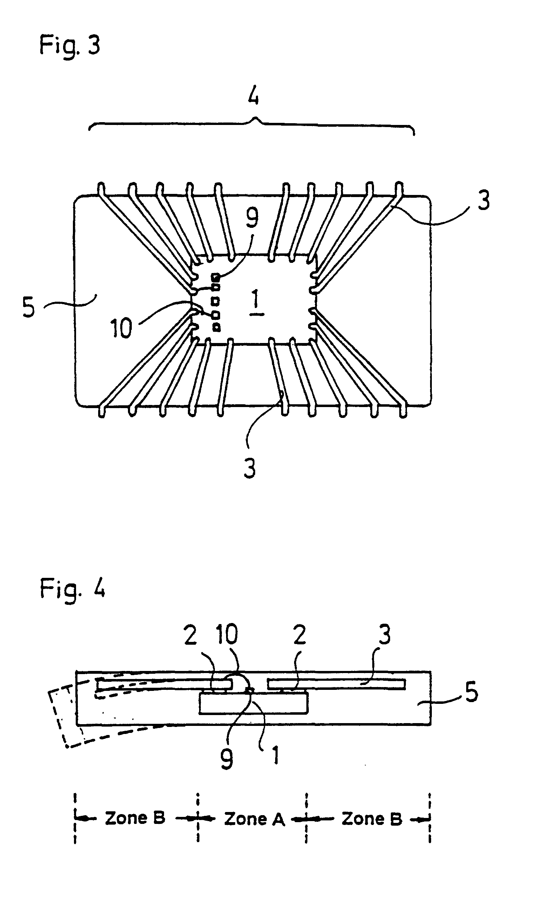

Fig. 3 zeigt eine Draufsicht auf eine bestehende integrierte Halbleiterschaltung, deren Querschnitt in Fig. 4 dargestellt ist. Diese integrierte Halbleiterschaltung umfaßt einen Halbleiterchip 1, auf diesem angeordnete Kontaktflächen 2, mit den Kontaktflächen 2 mechanisch verbundene Leiter 3 eines Leiterrahmens 4, zur elektrischen Verbindung zwischen den Leitern 3 und elektrischen Kontakten ("Bondpads") 9 dienende Bonddrähte 10 aus beispielsweise Gold, sowie ein Gehäuse 5 aus einer Preßmasse, beispielsweise Epoxidharz. Zur Vereinfachung der Darstellung sind die Kontaktflächen 2 lediglich in Fig. 4 dargestellt, die im übrigen die Leiter 3 so zeigt, als wäre das Gehäuse 5 weggelassen. Wie nun aus den Fig. 3 und 4 zu ersehen ist, wird hier der relativ kleine Halbleiterchip 1 in dem im Vergleich hierzu großen Gehäuse 5 untergebracht. Es gibt so eine Zone A, in der in einem Seitenschnitt der Halbleiterchip 1 und das Gehäuse 5 vorliegen, während in Zonen B, die außerhalb des Bereiches des Halbleiterchips 1 sind, nur die Leiter 3 des Leiterrahmens 4 sowie die Preßmasse des Gehäuses 5 vorhanden sind. Obwohl die Fig. 3 und 4 ein Beispiel zeigen, bei dem der Halbleiterchip 1 zentrisch im Gehäuse 5 angeordnet ist, sind diese Zonen B, die in den Fig. 3 und 4 links und rechts von dem Halbleiterchip 1 gelegen sind, relativ groß. Bei einer nichtzentrischen Anordnung des Halbleiterchips 1 im Gehäuse 5, also bei einer etwa in den Fig. 3 und 4 nach links verschobenen Unterbringung des Halbleiterchips 1 im Gehäuse 5, würde eine dieser Zonen B, im gegebenen Beispiel die in den Fig. 3 und 4 rechts gelegene Zone B, in ihren Abmessungen noch größer werden.

Dies bedeutet, daß bei der dargestellten integrierten Halbleiterschaltung in der Zone A der Halbleiterchip 1 und das Gehäuse 5 vorhanden sind, während in den Zonen B das Gehäuse 5 und die Leiter 3 vorliegen. Die Wärmeausdehnungs-Koeffizienten des Halbleitermaterials des Halbleiterchips 1 und des Leiters 3 relativ nahe beieinander. Der Wärmeausdehnungs-Koeffizient der Preßmasse des Gehäuses 5 weicht aber erheblich von den Wärmeausdehnungs-Koeffizienten des Halbleitermaterials und des Leiters ab. Damit ist die integrierte Halbleiterschaltung in der Zone A thermisch abgeglichen ("balanced package"), während eine derartige thermische Abgleichung in den Zonen B nicht vorliegt ("none-balanced package"). Bei der integrierten Halbleiterschaltung tritt so eine Durchbiegung auf, die in Fig. 4 in Strichlinien angedeutet ist. Eine derartige Durchbiegung ist um so größer, je geringer die Dicke des Gehäuses 5 ist und je ausgedehnter die Zonen B sich über die Zone A hinaus erstrecken. Für die Montage der integrierten Halbleiterschaltung sind derartige Durchbiegungen äußerst unerwünscht, da durch sie die Gehäuseabmessungen der integrierten Halbleiterschaltung verändert werden und eventuell deren Koplanarität mit anderen Bauteilen verloren geht. Dies kann einen negativen Einfluß sowohl auf die mechanischen als auch auf die elektrischen Eigenschaften des Produkts haben.

In Patent Abstracts of Japan 18(643) (E1640) and JP-A-6252333 ist eine Halbleiteranordnung beschrieben, die einen Halbleiterchip, einen Leiterrahmen und ein umgebendes Gehäuse aufweist. Der Halbleiterchip ist auf eine Chipinsel des Leiterrahmens aufgebracht. Die Anschlußfinger sind derart geformt, daß in alternierender Weise einmal Teile der Anschlußfinger an der Oberseite des Halbleiterbauelements zugänglich sind, ein andermal Teile an der Unterseite des Halbleiterbauelementes zugänglich sind. Es existieren weiterhin Anschlußfinger, die auf der Seite des Gehäuses nach außen geführt sind. Auf diese Weise kann ein großer Pitch-Abstand der Anschlußfinger erzielt werden.

In Patent Abstracts of Japan 16(014) (E1154) and JP-A-3235360 ist eine Halbleiteranordnung mit einem Halbleiterchip, einem Leadframe und einem umgebenden Gehäuse beschrieben. Dabei sind die einen Enden der Anschlußfinger nach dem Lead on Chip-Prinzip auf eine Oberseite des Halbleiterchips befestigt. Die Bereiche der Anschlußfinger, die sich im inneren des Gehäuses befinden, weisen eine abgestufte Form auf, so daß sie das Gehäuse in der Mittelebene durchstoßen. Der Halbleiterchip kann, bedingt durch die Stufe in den Anschlußfingern, etwa in der Mittelebene des Gehäuses angebracht werden.

Es ist die **Aufgabe** der vorliegenden Erfindung, eine integrierte Halbleiterschaltung zu schaffen, bei der Durchbiegungen des Gehäuses auch dann zuverlässig vermieden sind, wenn in dem Gehäuse der eigentliche Halbleiterchip nur einen relativ kleinen Raum einnimmt und Leiter nicht-zentrisch geführt sind.

Diese Aufgabe wird bei einer integrierten Halbleiterschaltung nach dem Oberbegriff des Patentanspruches 1 erfindungsgemäß dadurch gelöst, daß der Leiterrahmen in dritten Bereichen, die zwischen den ersten und zweiten Bereichen gelegen und außerhalb des Umfanges des Halbleiterchips angeordnet sind, aus der Ebene der ersten und zweiten Bereiche zu der den Kontaktflächen gegenüberliegenden Oberseite des Halbleiterchips abgesenkt sind. Diese Absenkung kann dabei beispielsweise so weit vorgenommen werden, daß die entsprechenden Teile der Leiter etwa in der Mittelebene der integrierten Halbleiterschaltung bzw. von deren Gehäuse liegen. Durch die Absenkung der Leiter des Leiterrahmens in den dritten Bereichen wird auch hier auf einfache Weise eine thermische Abgleichung erreicht, so daß eine Durchbiegung zuverlässig vermieden wird. Die Absenkung selbst kann auf einfache Weise erreicht werden, indem der Leiterrahmen bei seiner Fertigung entsprechend geprägt wird. Der durch eine solche Prägung entsprechend gestaltete bzw. mit abgesenkten Teilen versehene Leiterrahmen wird dann in üblicher Weise mit dem Halbleiterchip verbunden und in das Gehäuse eingegossen.

Eine Weiterbildung der Erfindung besteht darin, daß die Absenkung der dritten Bereiche bis etwa zur Mittelebene des Gehäuses geführt ist. Befinden sich nämlich in den dritten Bereichen die Leiter des Leiterrahmens etwa im gleichen Abstand von der Oberseite und der Unterseite der integrierten Halbleiterschaltung bzw. von deren Gehäuse, so ist hier ohne weiteres eine thermische Abgleichung erreicht.

Obwohl die vorliegende Erfindung nicht auf spezielle Materialien für Leiterrahmen und Gehäuse beschränkt ist, da die thermische Abgleichung dann vorliegt, wenn der Leiterrahmen etwa im gleichen Abstand zur Oberseite und Unterseite des Gehäuses angeordnet ist, so sind doch bevorzugte Materialien für den Leiterrahmen Nickel/Eisen und Kupferlegierungen und für das Gehäuse Preßmassen auf Epoxi-Basis.

Eine andere Weiterbildung der Erfindung besteht darin, daß die dritten Bereiche in solchen Zonen der integrierten Halbleiterschaltung gelegen sind, in denen der Abstand zwischen dem Halbleiterchip und dem Rand des Gehäuses am größten ist. Auf diese Weise können besonders große Durchbiegungen des Gehäuses zuverlässig vermieden werden.

Schließlich besteht eine Weiterbildung der Erfindung noch in einem Verfahren zur Herstellung der integrierten Halbleiterschaltung, wobei die Absenkung in den dritten Bereichen durch Niederprägen bei der Herstellung des Leiterrahmens vorgenommen wird und sodann der Halbleiterchip mit dem Leiterrahmen verbunden und mit dem Gehäuse vergossen wird. Auf diese Weise ist eine besonders einfache Absenkung des Leiterrahmens möglich.

Nachfolgend wird die Erfindung anhand der Zeichnungen näher erläutert. Es zeigen
- Fig. 1: eine Seitenansicht der erfindungsgemäßen integrierten Halbleiterschaltung;
- Fig. 2: eine Draufsicht auf die Halbleiterschaltung von Fig. 1;
- Fig. 3: eine Draufsicht auf eine bestehende integrierte Halbleiterschaltung, und
- Fig. 4: eine Seitenansicht der Halbleiterschaltung von Fig. 3.

In den Fig. 1 bis 4 sind der Halbleiterchip und die Leiter des Leiterrahmens zur Verdeutlichung der Erfindung dargestellt, obwohl diese an sich weitgehend durch das Gehäuse 5 verdeckt sind. Außerdem sind in allen Figuren einander entsprechende Teile mit den gleichen Bezugszeichen versehen.

Wie in den Fig. 1 und 2 gezeigt ist, sind hier die Leiter 3 des Leiterrahmens 4, die Kontaktflächen 2 des Halbleiterchips 1 mit äußeren Anschlüssen 7 der integrierten Halbleiterschaltung verbinden, in Bereichen 6 abgesenkt. Diese Bereiche 6 sind in Fig. 2 strichliert gezeigt und liegen insbesondere in den Teilen der integrierten Halbleiterschaltung, in denen der Abstand zwischen dem Halbleiterchip 1 und dem Rand des Gehäuses 5 relativ groß ist. Auf diese Weise entsteht in den Leitern 3 in den Bereichen 6 eine Absenkung 8 (vergleiche Fig. 1), die etwa in der Mittelebene 9 des Gehäuses 5 gelegen ist. Damit ist die integrierte Halbleiterschaltung auch in den Bereichen 6 thermisch abgeglichen, da durch den etwa gleichen Abstand der Absenkung 8 von der Oberseite und der Unterseite des Gehäuses 5 bei einer Erwärmung eine Durchbiegung zuverlässig vermieden wird. Aus Gründen der besseren Darstellung sind in den Fig. 1 und 2 die Kontakte 9 und Bonddrähte 10 nicht gezeigt.

Die Erfindung ist vorteilhaft auf alle integrierten Halbleiterschaltungen in LOC- bzw. CDL-Technologie anwendbar, bei denen die Leiter eines Leiterrahmens mit einfachen Mitteln in einen abgeglichenen Zustand gebracht werden sollen.

## Patentansprüche

1. Integrierte Halbleiterschaltung, insbesondere Halbleiterspeicher, mit einem Halbleiterchip (1), einem den Halbleiterchip (1) und einen Leiterrahmen (4) aus einzelnen Leitern (3) aufnehmenden Gehäuse (5) zur Verbindung zwischen Kontaktflächen (2) des Halbleiterchips (1) und äußeren Anschlüssen (7) der integrierten Halbleiterschaltung, wobei mit den Kontaktflächen (2) verbundene erste Bereiche des Leiterrahmens (4) und mit den äußeren Anschlüssen (7) verbundene zweite Bereiche des Leiterrahmens (4) im wesentlichen in einer gleichen Ebene gelegen sind, wobei die Leiter (3) des Leiterrahmens (4) in dritten Bereichen (6), die zwischen den ersten und zweiten Bereichen gelegen und außerhalb des Umfangs des Halbleiterchips (1) angeordnet sind, aus der Ebene der ersten und zweiten Bereiche zu der den Kontaktflächen (2) gegenüberliegenden Oberseite des Halbleiterchips (1) abgesenkt sind,
**dadurch gekennzeichnet,**
**daß** die Absenkung der Leiter (3) den Leiterrahmen (4) in den dritten Bereichen (6) bis etwa zur Mittelebene des Gehäuses (5) geführt ist.

2. Integrierte Halbleiterschaltung nach Anspruch 1,
**dadurch gekennzeichnet,**
**daß** der Leiterrahmen aus Nickel/Eisen und Kupferlegierungen und das Gehäuse aus Preßmassen auf Epoxi-Basis bestehen.

3. Integrierte Halbleiterschaltung nach einem der Ansprüche 1 oder 2,
**dadurch gekennzeichnet,**
**daß** die dritten Bereiche (6) in solchen Zonen der integrierten Halbleiterschaltung gelegen sind, in denen der Abstand zwischen dem Halbleiterchip (1) und dem Rand des Gehäuses (5) am größten ist.

4. Verfahren zum Herstellen der integrierten Halbleiterschaltung nach einem der Ansprüche 1 bis 3,
**dadurch gekennzeichnet,**
**daß** die Absenkung der Leiter (3) in den dritten Bereichen (6) durch Niederprägen bei der Herstellung des Leiterrahmens (4) vorgenommen wird und daß dann der Halbleiterchip (1) mit dem Leiterrahmen (4) verbunden und mit dem Gehäuse (5) vergossen wird.

## Claims

1. Integrated semiconductor circuit, in particular semiconductor memory, having a semiconductor chip (1) and a housing (5), accommodating the semiconductor chip (1) and a lead frame (4) comprising individual conductors (3), for the purpose of connection between contact areas (2) of the semiconductor chip (1) and external connections (7) of the integrated semiconductor circuit, first regions of the lead frame (4), which are connected to the contact areas (2), and second regions of the lead frame (4), which are connected to the external connections (7), being located essentially in an identical plane, the conductors (3) of the lead frame (4) being sunk in third regions (6), which are located between the first and second regions and are arranged outside the periphery of the semiconductor chip (1), from the plane of the first and second regions to the top side of the semiconductor chip (1), said top side being situated opposite the contact areas (2),
**characterized**
**in that** the sinking of the conductors (3) of the lead frame (4) in the third regions (6) is taken approximately as far as the central plane of the housing (5).

2. Integrated semiconductor circuit according to Claim 1,
**characterized**
**in that** the lead frame is composed of nickel/iron and copper alloys and the housing is composed of epoxy-based moulding compounds.

3. Integrated semiconductor circuit according to either of Claims 1 and 2,
**characterized**
**in that** the third regions (6) are located in those zones of the integrated semiconductor circuit in which the distance between the semiconductor chip (1) and the edge of the housing (5) is greatest.

4. Method for producing the integrated semiconductor circuit according to one of Claims 1 to 3,
**characterized**
**in that** the sinking of the conductors (3) in the third regions (6) is performed by embossing during the production of the lead frame (4), and in that the semiconductor chip (1) is then connected to the lead frame (4) and encapsulated with the housing (5).

## Revendications

1. Circuit intégré à semi-conducteur, notamment mémoire à semi-conducteur, comprenant une puce (1) à semi-conducteur, un boîtier (5) recevant la puce (1) à semi-conducteur et un cadre (4) constitué de divers conducteurs (3) pour obtenir la liaison entre des surfaces (2) de contact de la puce (1) à semi-conducteur et des bornes (7) extérieures du circuit intégré à semi-conducteur, de premières parties du cadre (4) de conducteurs, qui sont reliées aux surfaces (2) de contact, et des secondes parties du cadre (4) de conducteurs, qui sont reliées aux bornes (7) extérieures, étant sensiblement dans un plan commun des conducteurs (3) du cadre (4) de conducteurs, étant abaissées dans de troisièmes parties (6) qui sont interposées entre les premières et les deuxièmes parties et qui se trouvent en-dehors du pourtour de la puce (1) à semi-conducteur, hors du plan des premières et deuxièmes parties vers la face supérieure, opposée aux surfaces (2) de contact, de la puce (1) à semi-conducteur,
**caractérisé en ce que** la partie abaissée des conducteurs (3) du cadre (4) de conducteurs dans les troisièmes parties (6) va jusqu'à environ le plan médian du boîtier (5).

2. Circuit intégré à semi-conducteur suivant la revendication 1, **caractérisé en ce que** le cadre de conducteurs est en alliages de nickel, de fer et de cuivre et le boîtier est en matières à mouler à base d'époxy.

3. Circuit intégré à semi-conducteur suivant l'une des revendications 1 ou 2, **caractérisé en ce que** les troisièmes parties (6) se trouvent dans des zones du circuit intégré à semi-conducteur, dans lesquelles la distance entre la puce (1) à semi-conducteur et le bord du boîtier (5) est la plus grande.

4. Procédé de fabrication du circuit intégré à semi-conducteur suivant l'une des revendications 1 à 3, **caractérisé en ce qu'**il consiste à obtenir l'abaissement des conducteurs (3) dans les troisièmes parties (6) par estampage lors de la fabrication du cadre (4) de conducteurs et ensuite à relier la puce (1) à semi-conducteur au cadre (4) de conducteurs et à la sceller au boîtier (5).
